Europäisches Patentamt

European Patent Office

Office européen des brevets

(11) Publication number: **0 071 439**

**B1**

(12) **EUROPEAN PATENT SPECIFICATION**

(45) Date of publication of patent specification: **02.10.85**

(51) Int. Cl.⁴: **G 01 R 31/36**

(21) Application number: **82303918.5**

(22) Date of filing: **23.07.82**

(54) Quiescent battery testing method and apparatus.

(30) Priority: **23.07.81 US 286271**

(43) Date of publication of application:
**09.02.83 Bulletin 83/06**

(45) Publication of the grant of the patent:
**02.10.85 Bulletin 85/40**

(84) Designated Contracting States:
**DE FR GB IT**

(56) References cited:
**FR-A-2 396 309**
**US-A-4 193 026**

(73) Proprietor: **CURTIS INSTRUMENTS, INC.**
**200 Kisco Avenue**
**Mount Kisco, NY 10549 (US)**

(72) Inventor: **Finger, Eugene P.**
**Old Milltown Road**
**Brewster New York 10509 (US)**

(74) Representative: **Slight, Geoffrey Charles et al**
**Graham Watt & Co. Riverhead**
**Sevenoaks Kent TN13 2BN (GB)**

Courier Press, Leamington Spa, England.

## Description

The present invention relates to methods and apparatus for determining the condition of charge of an electric storage battery such as a lead acid battery under quiescent conditions when there is no current flow through the battery terminals.

### Background of the invention

Many different approaches have been made to the problem of monitoring and indicating the discharge condition of electric storage batteries, especially in applications where the battery is first charged and then is used in the discharge mode for a considerable period of time, such as in a mobile vehicle, before it is again returned to the charger to be re-charged.

Various battery terminal voltage measurement systems have been employed for the purpose of monitoring battery discharge, with varying degrees of success. The present invention is essentially in this category.

One approach is simply to measure and read the instantaneous battery terminal voltage on a continuing basis. However, this requires interpretation, since the terminal voltage varies during operation of the apparatus powered by the battery, having a depressed value during loading, dependent upon the magnitude of the load.

Various unidirectional systems have been devised for detecting and registering downward excursions in battery voltage under load, as an indication of the discharge condition of the battery. Some of these have operated on the basis of recognition of a sustained undervoltage condition before any registration is made, and others are really undervoltage analyzers which recognize and register undervoltage conditions in a setting recognizing previously registered undervoltage conditions. Very accurate results have been obtained with such systems especially when applied to apparatus having known patterns of loading, even where the loading is quite discontinuous, such as in the operation of industrial fork lift trucks. Examples of successful systems of this sort are disclosed in a prior U.S. patent 4,193,026 issued to Eugene P. Finger and Eugene A. Sands on March 11, 1980 and assigned to the same assignee as the present application.

The above mentioned devices are sometimes referred to as "fuel gauges" since they are intended to indicate how much operating capacity remains in the battery of the vehicle. These devices are intended to be continuously connected to the vehicle or apparatus whose batteries are being monitored so as to analyze the operating history of the battery as a basis for a continuing calculation and indication of the remaining charge on the battery.

There is an important need for a battery tester which is capable of easily and conveniently providing an indication of the charge state of a battery without the necessity for having the device constantly connected to, or associated with, the battery. Such a tester would be especially valuable in a battery charging facility where it may be desired to determine the charge state of batteries which are held in temporary storage to make certain which batteries have been charged, and whether they have been fully charged or not, or to determine how much charge they need if they are not charged. Such a tester or testing method would also be useful for the purpose of determining the charge state of batteries in an electric vehicle or other apparatus which is not equipped with a "fuel gauge" of sufficient accuracy, or which has no "fuel gauge".

One of the most common present methods for determining the state of charge of batteries in a test procedure is by checking the specific gravity of the fluid electrolyte. This means removing the cap from each battery cell, inserting the electrolyte tester tube into that cell, drawing electrolyte liquid into the tester, waiting until the fluid level is steady, and then attempting to read the position of the meniscus of the fluid in the tester in relation to a float scale to provide a specific gravity reading. The fluid must then be returned to the cell and the cell cover again closed. This procedure must be repeated eighteen times for a thirty-six volt battery to have a complete reading.

Even if a sampling procedure is used, in which three or four cells are tested, and the others are assumed to be the same, the procedure is still very time consuming and the accuracy of the reading is seriously limited. Another very serious problem with the accuracy of the reading arises from the fact that it is only the stabilized steady state specific gravity of the electrolyte which is an accurate indication of the state of charge of the battery. Thus, if the battery has been in a non-quiescent condition (connected for either charge or discharge) for less than a number of hours before the specific gravity is taken, the specific gravity reading is not an accurate indication of the remaining state of charge. Many hours are required for the specific gravity to stabilize sufficiently to provide a reasonably accurate reading. Furthermore, there is always a risk of spilling the battery acid electrolyte. Accordingly, the conventional specific gravity measurement has a number of serious disadvantages.

There is also an important need for a battery tester which is simply capable of quickly providing an indication as to whether a battery was last subjected to a charge or discharge operation. In a battery charging facility, this will provide a quick confirmation as to which batteries have already been charged, and which batteries still need to be charged.

### Summary of the invention

It has been recognized that one of the most accurate voltage measurements for indicating the battery state of charge for many battery systems, including lead-acid, is the stabilized open circuit battery terminal voltage. That voltage is very closely related to the stabilized specific gravity of the electrolyte. However, it typically takes a number of hours or even days for the open circuit battery voltage to stabilize after each charge or discharge interval, so that the stabilized reading is simply not available without an impractical wait for the stabilized condition. Usually, the battery state of charge information is needed most while the battery is being discharged or charged, or soon after a discharge or charge interval.

It is an object of the present invention to provide a new method and apparatus utilizing battery terminal voltage measurements for determining the state of charge of the battery.

It is another object of the invention to provide a new battery state of charge indicating method and apparatus which may be based solely upon measurements of battery terminal voltage under quiescent conditions.

It is another object of the present invention to provide a method and apparatus for measuring battery terminal voltages under quiescent battery conditions in such a way as to provide an accurate prediction of the ultimate stabilized open circuit battery terminal voltage as a basis for indicating the state of charge of the battery.

It is still another object of the invention to provide a method and apparatus for quickly indicating whether the battery was last charged or discharged.

The present inventor has discovered that after an interval of current flow through a battery, (a current exchange operation) either because of charging or discharging, the battery terminal voltage tends to adjust rapidly, during an initial brief interval after discontinuance of the current, to a voltage value which is substantially independent of the magnitude of the prior current flow through the battery, and which is substantially completely dependent upon the state of charge of the battery. However, from that point on, the terminal voltage value continues to change as a very predictable function of the elapsed time after current interruption, adjusting towards the ultimate stabilized open circuit voltage. The present invention takes advantage of this principle by taking at least two time separated battery terminal voltage samples when the battery is quiescent, and relating those samples to the known voltage recovery characteristics of the battery.

In carrying out the invention, there may be provided a quiescent battery testing method for testing a battery which is not connected to a load or to a charging source comprising the steps of taking a first battery terminal voltage measurement, noting said first measurement, taking a second terminal voltage measurement at a subsequent time, and comparing said second measurement with said first measurement to determine the direction of voltage change from said first measurement to said second measurement as a basis for determining whether the battery was last subjected to charge or discharge.

Brief description of the drawings

Fig. 1 shows typical plots of battery terminal voltage recovery curves versus time after termination of battery current at various states of charge, with an expanded voltage scale and a logarithmic time scale.

Fig. 2 is a modified version of Fig. 1, in which time is plotted in hours, rather than minutes, and in which the voltage curves are shown as idealized logarithmic functions of time.

Fig. 3 is a schematic circuit diagram illustrating one preferred apparatus for carrying out the invention and employing a fixed interval of time between two different voltage measurements.

Fig. 4 is a schematic circuit diagram of another preferred apparatus for carrying out the invention in which a variable time interval is measured for the achievement of a predetermined voltage difference between two voltage measurements.

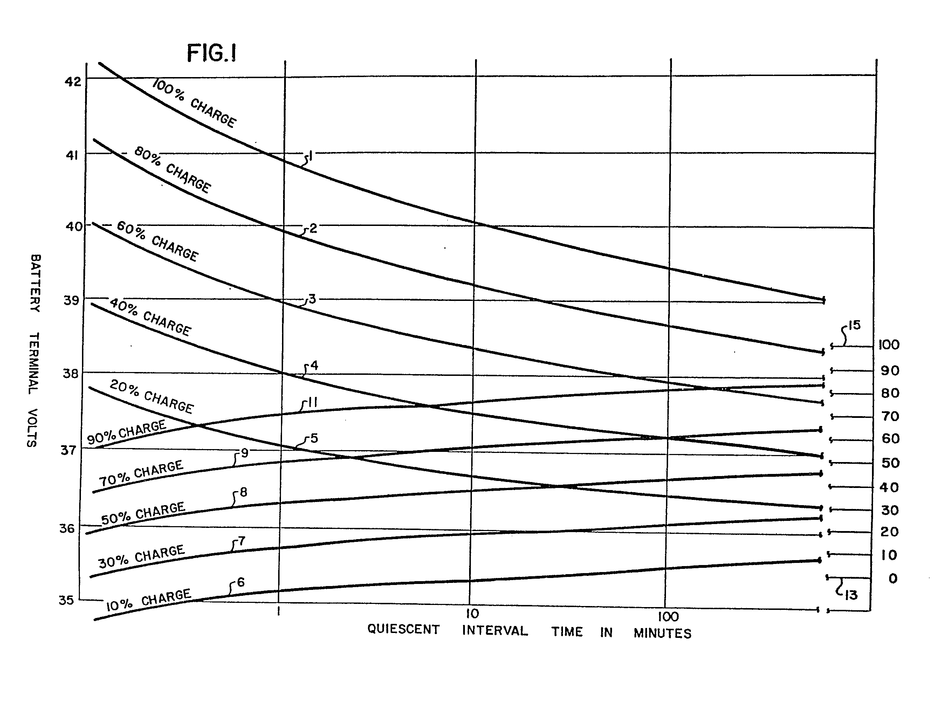

Description of preferred embodiments Referring more particularly to Fig. 1, there is shown two series of voltage curves plotted on an expanded vertical scale for nominal 36 volt battery systems. These curves are plotted on a logarithmic horizontal scale representing the time duration of the quiescent interval after termination of battery current. The upper set of curves, designated 1 through 5, which incline downwardly, represent battery open circuit voltage respectively at different states of charge versus time after termination of a charge operation. The lower set of curves designated 6 through 9 and 11, which incline upwardly, represent battery open circuit voltage respectively at different states of charge versus time after termination of a discharge operation.

Curve 1 represents the condition of 100% charge, and it is so marked. Curves 2, 3, 4, and 5 respectively represent 80% charge, 60% charge, 40% charge, and 20% charge states. Similarly, curves 6 through 9 and 11 respectively represent 10%, 30%, 50%, 70%, and 90% charge states, and are respectively so marked.

The curves represent voltage stabilization characteristics to be expected from a particular 800 ampere hour lead acid traction battery having 18 cells at a temperature of 25°C. The curves are typical of those to be expected from this battery type. For this battery, the ultimate stabilized open circuit voltage may be expressed as a function of battery charge to a very close approximation by the following expression:

Open circuit voltage=35.46+0.0288 P.

(Where P=the percent of full charge on the battery).

This expression calls for a fully discharged stabilized open circuit voltage of 35.46, and a fully charged stabilized open circuit voltage of 38.34 volts. These values are respectively shown, for reference purposes, in Fig. 1 at the right margin of the drawing at 13 and 15. Stabilized open circuit voltages for intermediate charge states are indicated at 10% intervals between the extreme values at 13 and 15. These stabilized open circuit voltage values are not related to the horizontal time scale since the stabilized voltage values are not actually achieved until a time substantially beyond the time scale shown, even though the time scale is a logarithmic scale.

The curves of Fig. 1 are idealized to some extent, but they generally represent the character of actual data on actual batteries. In the earliest portions of the quiescent intervals, up to about one tenth of a second, the recovery voltage characteristic has been found to be very much dependent upon the magnitude of the prior battery current. However, it has been discovered that after about one tenth of a minute, and especially after about one minute, all of the curves become quite mathematically predictable and regular, and appear to be substantially independent of the magnitude of the current prior to commencement of the quiescent interval, as long as there is a substantial energy transfer in a nominal period of time. Thus, the curves are almost straight lines, as plotted on the horizontal logarithmic scale, and thus represent essentially logarithmic functions, or at least predictable exponential functions. Because of this, the curves represent a basis for accurate prediction of the ultimate steady state open circuit terminal voltage, and that p.ediction provides a basis for accurately indicating the state of charge of the battery.

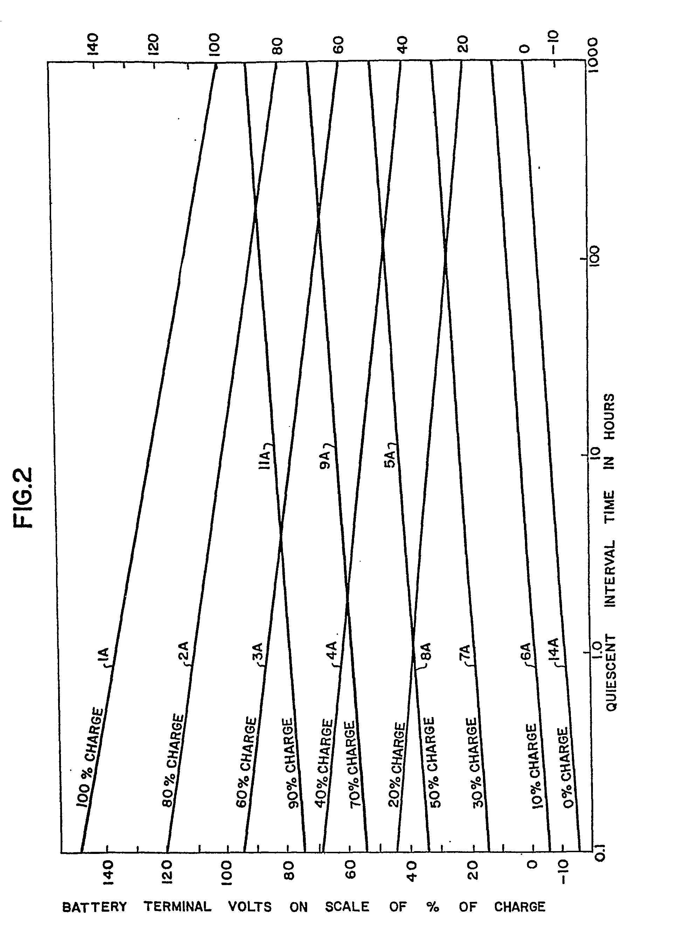

Fig. 2 is an idealized redrawing of Fig. 1 in which the quiescent interval time is plotted in hours, rather than in minutes, beginning with 1/10 of an hour (6 minutes) and continuing to 1000 hours, which is a very substantial extension of the time scale over Fig. 1. Additionally, in Fig. 2, the vertical scale is shown entirely in terms of the percent of stabilized battery capacity (as indicated by the stabilized terminal voltage) rather than by use of a battery terminal voltage scale.

One thousand hours corresponds to almost 42 days, which is much more than enough time to achieve stabilization for most batteries, and it may actually be so far into the quiescent state that "self-discharge" effects will have set in.

The curves of Fig. 1 are all again shown in Fig. 2, and are designated with the same numbers, but with a suffix letter A. Thus, curve 1 of Fig. 1 is again shown in Fig. 2 as curve 1A. The curves of Fig. 2 are idealized as straight lines on a semi-logarithmic plot. It has been found that such lines provide a rather accurate representation of the voltage recovery characteristics of the terminal voltage of the battery, particularly for the time intervals shown from about 6 minutes after the beginning of quiescence to 1000 hours. It has been found that the recovery curves from a last previously charged state, curves 1A, 2A, 3A, 4A, and 5A, do not have a common slope. Thus, the 100% charge curve 1A has a slope of about minus 12% per decade, the 80% charge curve 2A has a slope of minus 10% per decade, the 60% charge curve 3A has a slope of minus 8% per decade, the 40% charge curve 4A has a slope of about minus 7% per decade and the 20% charge curve 5A has a slope of about 6% per decade. In this context, a "decade" refers to the interval on the horizontal scale from one point to a subsequent point which represents 10 times the elapsed time. Thus, from 1 to 10 on the horizontal scale is one "decade".

By contrast, the curves 6A through 11A, and 14A, which represent voltage recovery from a discharge state have an almost uniform slope of about 4% per decade. In addition to all of the curves discussed above, which are illustrated in Fig. 1 and repeated in Fig. 2, Fig. 2 includes an additional curve 14A at the bottom of the figure which relates to a 0% charge condition.

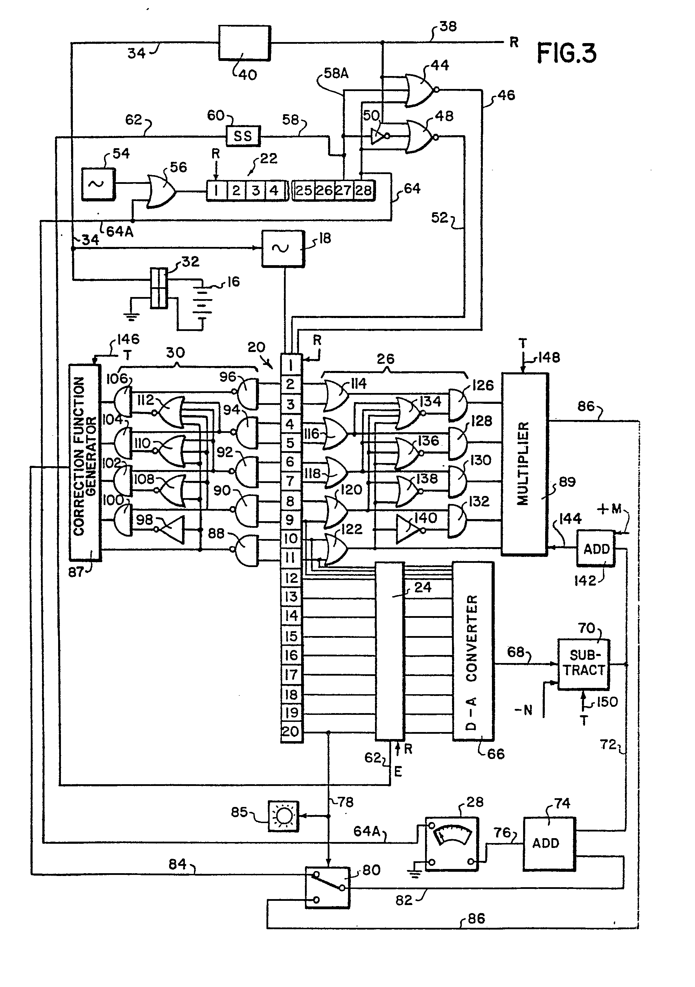

Fig. 3 is a schematic circuit diagram illustrating a preferred embodiment of apparatus in accordance with the invention for carrying out the method according to the invention. The apparatus can be very briefly described as follows:

The battery for which the state of charge is to be determined is schematically illustrated at 16. The battery 16 is connected to a voltage controlled oscillator 18 which is connected to a counter 20. The counter 20 is caused to count up for a predetermined fixed interval of time, as determined by a clock counter 22, to record a measurement of the battery voltage in digital form in terms of the count stored in the counter 20. Since the oscillator frequency is a function of voltage, the pulse count over a fixed interval is a function of voltage. The higher order digits of that count are then transferred to a register 24 for storage of the first voltage measurement for future use, and the counter 20 is then reversed to count down during a second voltage measurement interval of the same fixed time duration. At the end of the countdown interval, the remainder within the counter 20 indicates the difference in voltage as measured by the two different measurements, such difference remaining in the lower order registers of counter 20. If the remainder in register 20 is positive, indicating a negative change in the voltage from battery 16, such positive remainder is analyzed by a digital logic network 26, and the result is used to modify the voltage value as stored in register 24, as will be described in more detail below, to provide a registration on a display meter 28 which indicates the state of charge of the battery 16. The negative change indicates a prior active condition of charging the battery.

On the other hand, if the remainder in the lower order registers of counter 20 is negative, indicating a rise in the second voltage measurement over the first voltage measurement, that condition is detected and analyzed by a digital network 30 which provides a different set of corrections to the voltage value stored in the register 24 for indication on the output meter 28 for the state of charge of the battery. The positive change indicates a prior active condition of discharging the battery.

The circuit of Fig. 3 is described in more detail as follows:

The apparatus is started by connecting the battery to the circuit by a connector schematically indicated at 32 which applies a logical 1 through connection 34 to a delay circuit 40, which may be a "single-shot" monostable multivibrator circuit.

Delay circuit 40 is immediately "set" to provide a logic 1 output at connection 38 for reset purposes as indicated by the symbol "R". The reset signal is applied to reset each of the counters 20, and 22, and the register 24. Simultaneously, power is supplied to all of the components of the circuit, permitting those components to stabilize in a condition ready for operation. While other power supplies may be provided in the apparatus, it is assumed that the apparatus will be powered by the battery being tested. Voltage dropping and voltage stabilizing circuits will normally be connected in line 34 for this purpose.

After a brief delay, as determined by delay circuit 40, that circuit resets and removes the logic 1 output at connection 38. This results in a logic zero output, terminating the reset signal on connection 38, and providing a logic zero signal to a NOR gate 44. The other two inputs to NOR gate 44 are already logic zero since they are the outputs from the 27th and 28th stages of the timing counter 22, which has just been reset. Accordingly, the NOR gate 44 provides a logic 1 output at connection 46. The signal on connection 46 is supplied to counter 20 as a "count-up" enabling signal, causing the counter 20 to commence its upward count in response to pulses from the voltage controlled oscillator 18. A NOR gate 48, which is similar to the NOR gate 44, is connected to receive the identical inputs supplied to NOR gate 44, except that an inverter 50 is provided between the output of stage 27 of timer counter 22 and the corresponding input of NOR gate 48. Therefore, at this time, NOR gate 48 is supplied with a logic "1" input from inverter 50 and continues to have a logic zero output on the output connection 52. The connection 52 provides a count down enable signal to counter 20 when it later goes to a logic 1. Substantially concurrently with the commencement of the count up operation of counter 20, the timer counter 22, having also had the reset signal removed, commences a count up operation under the control of a timer oscillator 54, which provides timing signals through an OR gate 56.

At the end of the initial timing interval, during which counter 20 counts up, a logic 1 appears at the output of the 27th stage of timing counter 22, which accomplishes three different functions. One of these functions is accomplished through a control circuit including connection 58, single shot 60, and connection 62 to the enable input of the register 24 to transfer the value stored in counter 20 into that register. That stored value is an indication of the first voltage value measured. Another function is the disablement of NOR gate 44 by the logic 1 supplied through connection 58A to that NOR gate, to discontinue the count up of counter 20. The third function is the enablement of NOR gate 48 by means of the logic 1 supplied to the input of inverter 50, which is then inverted to logic zero, to provide the logic 1 output from NOR gate 48 as the countdown enablement signal to counter 20 through connection 52.

After a countdown interval equal to the previous count up interval, the timer counter 22 counts up again until stage 27 of the timer counter 22 again goes to logic zero and stage 28 goes to logic 1. The logic 1 output from stage 28 disables the NOR gate 48, and maintains the disablement of NOR gate 44 so that the counter 20 continues to hold and store the difference value achieved in the count up and subsequent countdown operations. Furthermore, a measurement completion signal is supplied from the output of stage 28 of counter 22 through a connection 64 to a second input to OR gate 56 to lock that OR gate so as to discontinue further transmissions of pulses to the timer counter 22. The completion signal is also supplied through a connection 64A to enable the output meter 28 to thereby provide a visual indication to the operator of the state of charge of the battery. That state of charge is computed by the remaining circuit components which are about to be described below.

Since the first counting up of timer counter 22 and the second counting up of timer counter 22 occur in an uninterrupted sequence, the resultant counting up and counting down of the voltage measurement counter 20 occur in two adjacent time intervals. This provides two time-spaced voltage measurements. The difference between the voltage measurements in the two adjacent time intervals represents the equivalent of two different instantaneous voltage measurements spaced apart in time by the equivalent of the time from the middle of the first voltage measurement interval to the middle of the second voltage measurement interval. If desired, the voltage measurement intervals can be separated to provide a greater voltage change. This would require only a minor modification of the circuit as shown.

There is a substantial advantage in accumulating the counts for the voltage measurements over finite intervals of time. It provides an averaging effect which minimizes any small aberrations or fluctuations in battery terminal voltage. It is obvious, however, that other methods of measurement could be employed, such as taking substantially instantaneous voltage measurements and storing those voltage measurements in sample and hold circuits, and then subtracting one from the other.

It has been discovered that it is possible to rather simply derive signals in conformity with the battery characteristics illustrated in Fig. 2 which, on the basis of the voltage measurement stored in register 24 and the voltage change detected in the lower stages of register 20 by the logic networks 26 and 30, determine the battery state of charge in terms of a predicted ultimate steady state terminal voltage value. This can be simply done by computing and adding a factor to the voltage measurement stored in register 24 which is determined on the basis of the voltage change as detected by the logic networks 26 and 30.

The digital quantity stored in register 24 is first converted from digital form to an analog voltage in a digital to analog converter 66. This voltage represents the full terminal voltage of the battery. Since the steady state terminal voltage of the battery does not go to zero when the battery is discharged, a zero offset must be introduced at some point in the system so that the meter 28 will read zero for a discharged battery and full scale for a fully charged battery (or vice versa). The zero correction is preferably adjustable, since the determination of the terminal voltage which is to be regarded as indicating a fully discharged condition is partly a matter of judgment and preference. However, a typical stabilized voltage per cell for a fully discharged battery is 1.969 volts, and a typical stabilized voltage per cell for a fully charged battery cell is 2.131 volts. In the present system, it is preferred to work with the zero corrected measurement voltage in further processing of the signals. Accordingly, a fixed factor N, corresponding to the stabilized "empty" voltage per cell, is subtracted from the output signal from converter 66 at 68 in a subtract circuit 70. The analog signal voltage at 68, and the factor N signal are preferably scaled down from the typical actual terminal voltage to provide for a full scale reading on meter 28 (after further correction) for a fully charged battery, and a zero reading for a fully discharged battery. The scales and voltages may be selected, for instance, to provide one volt at meter 28 to indicate 100% charge. The subtract circuit 70 may be simply carried out by means of an amplifier with the inputs combined in a resistor network so that the voltage output is offset by the amount of the subtracted offset signal N.

The offset corrected signal is supplied on a connection 72 to an analog add circuit 74, where a correction is added through a connection 82 based upon the detected change in the voltage to the second voltage measurement. The corrected signal is then supplied from the adder 74 through connection 76 to the meter 28. Add circuit 74 may also consist of an amplifier with a resistance network to combine the two input signals at a common amplifier input.

If the two successive voltage measurements indicate a negative remainder in counter 20 (indicating a rising terminal voltage), then a correction to be applied at the adder 74 is determined by the logic network 30. This rising terminal voltage condition indicates a last previous non-quiescent status of the battery in the discharge mode. This refers back to the curves 6A through 11A, and 14A, of Fig. 2. The negative remainder condition in counter 20 is characterized by having the counter go into the complement mode, in which, after having counted down to zero, all of the stages of the counter are shifted to the "one" state, and then counted down in the complement mode. This complemented condition is recognized and used by detecting a 1 output from the 20th stage of counter 20 on a connection 78 to a visual indicator 85 to an electronic switch 80.

For some purposes, it is only necessary that the operator be informed as to whether the battery was previously in the charge mode or in the discharge mode. The signal to the visual indicator 85 (shown as a lamp) provides the information that the battery was last in the discharge mode. Another visual indicator also could be provided to indicate the opposite situation where the battery was last in the charge mode. When no further information is required, the remainder of the system, not yet described, may be omitted, along with all of the other components connected to receive, directly or indirectly, the outputs from the various stages of counter 20. However, in this description, it is assumed that a quantitative reading of battery charge is required.

Switch 80 determines whether the correction signal to adder 74 on input connection 82 is to be supplied from network 30 and a function generator 87 on connection 84, or from network 26 and a function generator 89 on connection 86. When a logic 1 signal is available at connection 78, the switch 80 is in the position shown to provide the correction signal on connection 84 from network 30 and a function generator 87 to connection 82 to the adder 74. In the absence of a logic 1 signal on connection 78, the switch 80 is switched to the other position to receive the correction signal through connection 86 from logic network 26 and a function generator 89. Switch 80 is a schematically illustrated electronic switch.

The logic network 30 is designed to provide a stepwise indication of the value of the remainder in counter 20. It has been discovered that stepwise corrections, with a reasonable number of steps, provide sufficient accuracy in the correction factor applied to the voltage to be indicated at indicator 28. Since the counter 20 is a binary digital counter, the highest value step in the negative residue value, as indicated by logic zeros in the 10th or 11th stage of the counter is in the range from a count of 512 to 2047. Thus, starting at the count 512, the 10th stage first goes to zero, and starting at the count 2048, the 12th stage first goes to zero, and the 10th and 11th stages both go to ones. The condition of the highest count range, in which either of the 10th or 11th stages provides a logic zero output, is detected by a NAND gate 88, which provides a logic one in that condition. Similarly the range step from 128 to 511 is detected by the NAND gate 90, and other lower order steps are detected by NAND gates 92, 94, and 96. The steps are respectively in the value ranges from 32 to 127, from 8 to 31, and from 2 to 7. However, in each lower range, other logic is necessary to make sure that the range has not been surpassed. Thus, in the range from 128 to 511, as determined by stages 8 and 9, there must be an assurance that the count has not already exceeded 511 by checking for logic zeros in stages 10 and 11. Therefore, the signal from NAND gate 88 is supplied through an inverter 98 to an AND gate 100, which also receives the output from gate 90, so that, unless there is a logic zero output from NAND gate 88, indicating that the value has not yet exceeded 511, there can be no signal provided from NAND gate 90 through AND gate 100 for an indication of that step value. Similarly, additional AND gates 102, 104, and 106 are provided for each of the other lower order ranges which are controlled by NOR gates 108, 110, and 112 to indicate that no higher order stages of the counter 20 have flipped over to zero.

The correction function generator 87 receives any one of the five stepwise signals from the logic network 30, and converts each of those signals to an appropriate correction factor for addition at adder 74. A sixth correction factor is available from the correction function generator 87 if none of the five inputs is available. This is the condition which exists when the remainder stored in counter 20 is a count of minus 1, or is in the positive instead of the negative range. However, this correction factor is only effective at the count of minus 1, because the counter 20 is not in the complement state when the remainder is positive. As explained previously, the counter 20 must be in the complement state in order to enable the switch 80 to obtain a correction from the correction function generator 87. At any rate, when the remainder in counter 20 is negative (in the complement mode) and at the smallest measurable count of minus 1, this sixth value from the correction function generator 87 is available at the output of that generator on connection 84.

Expressing the corrections in percent of full charge, it has been determined that appropriate and typical corrections to be applied at the adder 74 from the function generator 87 in response to the detection of residual count ranges from the counter 20 are as follows for a typical lead acid cell:

TABLE 1

| Range of residue count | Add following percent |
|---|---|
| −1 | 4 |
| −2 to −7 | 8 |
| −8 to −31 | 11 |
| −32 to −127 | 14 |
| −128 to −511 | 17 |
| −512 to −2047 | 20 |

In the above table, the corrections are given in percent. In terms of voltage, if a one volt output is used to indicate 100% charge, the values in the right column in the above table correctly indicate hundredths of a volt to be added in the adder 74.

As a specific example which ties in the above Table 1 values and the operation of the circuit of Fig. 3 with the curves illustrated in Fig. 2, attention is directed to curve 7A for the recovery from a discharge condition in a 30% charge state. The beginning of that curve, at 0.1 hours after quiescence begins is at a value of 14 on the zero corrected percent of charge scale. Thus, the zero corrected output from subtractor 70 would be 0.14 volts. The rate of change detected at 0.1 hours would be in the range of counts in Table 1 at the step of −128 to −511. Therefore, the correction voltage provided by the correction function generator 87 would be 0.17, which when added to the previous value of 0.14 in the adder 74 provides 0.31 volts, which provides a close approximation to a 30% charge reading on meter 28.

It will be apparent that the correction values given above for the stepwise voltage measurement residue counts essentially represent approximate anti-logarithmic functions of the residue counts. While a greater number of steps could be taken to provide greater precision, or a continuous computation could be made, it has been discovered that these stepwise approximations are adequate for providing a measurement within the limits of accuracy within the apparatus. The relationships stated in the above Table, together with the zero corrected voltage measurement available from subtractor 70, represent a means for matching the data plotted in Fig. 2 for the recovery curves from a prior discharge condition within this apparatus for computing the state of charge. The correction factors shown in the above Table 1 for the different steps have been selected to match with the slopes of the curves for a particular battery. A different table of correction factors can be selected for a different battery.

The correction function generator 87 can be carried out in various ways which are known to the art. For instance, the five logic network 30 outputs may control five electronic switches which connect different voltages from different parts of a voltage divider network to the output connection 84 to be added into the adder 74.

To produce the above mentioned counts in counter 20 in the apparatus of Fig. 3, when it is designed to operate with a battery 16 with a nominal 36-volt rating, the voltage controlled oscillator 18 may be selected to produce 34,293.55 counts per minute per volt. If greater resolution is desired on the low end of the scale, an oscillator which operates at a higher frequency per volt may be employed, with appropriate adjustments of the correction functions supplied from the correction function generator 87. Greater resolution can also be achieved by designing the circuit to provide for an accumulation of the counts over longer timing intervals than one minute, or by time separation of the two timing intervals.

Logic network 26 operates on principles similar to network 30 to respond to a positive residual in counter 20. The positive residual indicates that the battery was last in a prior charge condition, and an appropriate voltage correction signal is needed. However, the situation is complicated by the fact that the slopes of the recovery curves from the prior charge condition are not perfectly uniform. Thus, the slopes are greater for higher conditions of charge, and lower for lower conditions of charge.

Again, five different steps of count values are detected corresponding to the count values discussed above in connection with the network 30. For this purpose, network 26 includes a series of five OR gates 114—122. OR gate 122 detects the condition where the residual count is in the range from 512 to 2047, and provides that signal as one of the input signals to function generator 89 which may be a variable gain amplifier. Thus, if the count is high enough so that either the 10th or 11th stages contain a binary 1, the OR gate 122 provides an output to the variable gain amplifier 89. In a similar manner, each of the OR gates 114—120 indicates the presence of a binary 1 in either one of a connected pair of stages of the counter. For each of the lower order steps, AND gates 126—132 are respectively provided to exclude the condition that higher order binary 1 digits exist. For this purpose, NOR gates 134—138, and an inverter 140, are provided. For instance, for a true indication for the second step by means of an output from AND gate 128, not only must there be a binary 1 in the 4th or 5th stage to provide a binary 1 output from OR gate 116, but there must not be a binary 1 output from any of the higher order OR gates 118, 120, and 122, as detected by the NOR gate 136, so that NOR gate 136 will continue to provide a logic 1 to AND gate 128.

In order to correct for the varying slopes of the battery voltage recovery from charge curves 1A—5A of Fig. 2, the corrections provided from the variable gain amplifier 89 are determined partly by the level of the voltage measured and stored in register 24. This is accomplished by providing the zero corrected output signal on connection 72 to the variable gain amplifier 89 through an adder 142. In the adder 142, a fixed signal M is added. It has been found that an appropriate constant M to be added corresponds to 50% of the full scale full charge signal. This is the signal indicated at the second input to adder 142. Adder 142 may be implemented by an amplifier with a resistor summing network for summing the two inputs. The output from adder 142 at connection 144 to the variable gain amplifier 89 is then amplified in the amplifier 89 by a selected one of five different amplification factors, determined by the step detected by the logic network 26. The resultant signal is then supplied through connection 86 to switch 80 and thus through connection 82 to the adder 74 for correction of the voltage to be supplied to the meter 28. Actually, the variable gain amplifier 89 is operable, in the absence of any one of the five inputs from network 26, to provide a predetermined small variable gain in recognition that the remainder value stored in register 20 is either zero or 1, and therefore the slope is so low that it is considered to be indeterminate. If desired, a sixth input can be provided to the variable gain amplifier 89 from the first stage of the counter 20, and that stage can be used to provide another gain factor different from any factor provided with a zero count.

For the battery which data is plotted in Fig. 2, the multiplication factors (amplification factors) provided by the variable gain amplifier (multiplier) 89 for the various different residue counts are preferably as shown in the following table:

TABLE 2

| Range of residue count | Multiplication (amplification) factor |
| --- | --- |
| 0 to 1 | −0.07 |
| 2 to 7 | −0.137 |
| 8 to 31 | −0.165 |
| 32 to 127 | −0.194 |
| 128 to 511 | −0.218 |
| 512 to 2047 | −0.242 |

By computing the correction to be applied to the voltage measurements from the register 24 in the manner described above, applying an offset signal in adder 142, and then accomplishing an effective signal multiplication by means of the variable gain amplifier 89, it has been found that a very close approximation can be achieved to an accurate prediction of the ultimate steady state quiescent voltage on the basis of the recovery terminal voltage characteristics from a previously charged condition, as illustrated in curves 1A through 5A of Fig. 2. The factoring in of the voltage level measurement supplied through the adder 142 provides for a recognition of the fact that the slopes of the curves 1A through 5A are not parallel, and that the variation of slope is a function of the voltage level.

A specific example will serve to illustrate the operation of the circuitry just described. Assuming that the condition is one of 100% charge, and that the battery has just been on charge 0.1 an hour earlier, the applicable curve on Fig. 2 is curve 1A, and the applicable point on curve 1A is the beginning of that curve at the left of the diagram, indicating a zero corrected voltage in terms of 148% of full charge. This means that the output from the subtract circuit 70 in Fig. 3, which applies the zero correction, will be 1.48 volts. The adder 142 adds .5 volts to provide a total of 1.98 volts at connection 144 at the input to amplifier 89. Since the maximum slope condition will have been detected, the multiplication factor from Table 2 will be −0.242, providing an output on connection 86 of −0.479 which is added (actually subtracted because it is a negative number) to the 1.48 volts in the adder 74 to provide a resultant voltage of just a trifle over 1 volt to the meter 28 as a correct indication of the full charge condition.

The computations are carried out by means of analog devices in Fig. 3. It will be quite apparent that digital logic could be easily employed, since the raw data from the counter 20 is in digital form, and since the logic networks 26 and 30 comprise digital elements. In a digital embodiment, the correction function generator 87 can be simply a "look up" table of values which are selected by the five inputs from the logic network 30. Similarly, the variable gain amplifier 89, in digital form, may simply comprise a multiplier with a "look up" table to select different multiplication factors. It will be apparent that the characteristics of the circuit could be easily changed by changing the "look up" tables in the correction function generator 87 and the variable gain amplifier 89. The adders 74 and 142, and the subtractor 70, are replaced by digital devices, and the digital-to-analog converter 66 is omitted. It will also be understood that, particularly in a digital version, an appropriately programmed microprocessor, with associated working memory, can be employed to carry out the functions of the system, with a minimum of special dedicated components.

The voltage recovery curves illustrated in Fig. 1 and Fig. 2 assume a substantial prior energy transfer between the battery and another device. For instance, those curves assume a normally heavy load applied for an interval of at least several minutes, or a normally heavy charge current applied for at least five minutes or so. Thus, a very brief interval of regenerative braking, or a very brief application of a normal load, or the application of a very light load for a longer interval, will not result in the substantial deviations of terminal voltage from the ultimate steady state voltages illustrated in Figs. 1 and 2. Consequently, the voltage recovery curves after such minor current exchange incidents will not be as steep. Therefore, the battery will appear to be closer to its steady state condition at the outset of the quiescent condition. It is one of the features and advantages of this invention that since the rate of change of the voltage is being measured, as well as the absolute value of the voltage, an accurate indication of the state of charge is obtained even though the prior current exchange incident was a relatively minor one. Thus, the method and apparatus automatically compensate for differences in the recovery curves caused by differences in the magnitude of the prior energy transfer. However, the compensation may not be exact.

The invention also tends to automatically compensate for variations in the temperature of the battery for battery systems in which changes in voltage fluctuations caused by changes in temperature are accompanied by similar changes in the voltage recovery characteristics. For instance, in such a system, under load, the terminal voltage will decrease more when the battery is cold. However, the voltage recovery curve will also present a steeper slope, and the battery will look to the system as though it is simply at an earlier stage in the recovery towards a steady state condition compared to operation at normal temperature.

However, it may be desirable to provide for specific modifications of the operation of the apparatus in response to temperature variations. While not illustrated in detail, the embodiment of Fig. 3 may incorporate a temperature sensing device to sense the temperature of the battery 16 and to modify the operation of the circuits in accordance with that sensed temperature. If the temperature is higher than normal, the battery becomes more electrochemically active, and if the temperature is lower than normal, the battery becomes less electrochemically active, modifying the voltage characteristics depicted in Fig. 2. In order to recognize changed conditions due to changes in temperature, a temperature signal derived from a temperature sensor at the battery 16 may preferably be applied, as indicated at 146 and 148 to the correction function generator 87 and to the variable gain amplifier 89, and as indicated at 150 to the subtract circuit 70. The temperature correction input to the subtract circuit 70 at 150 will change and adjust, on a continuous, or in a stepwise manner, the offset correction of the voltage value derived from the number stored in register 24. The temperature correction at 146 to the correction function generator 87 will modify the correction functions selected by each of the five inputs to the correction function generator 87 from network 30. This modification may likewise be on a continuous, or a in a stepwise manner. In a digital embodiment, the detection of a temperature above or below certain limits may simply switch in a new "look up" table of values to be selected by the five inputs. In a similar manner, the temperature correction input at connection 148 may select different variable gain values for the amplifier 89.

Fig. 3 illustrates an embodiment of the invention in which two voltage measurements are made at a fixed time separation, and the voltage difference over the fixed time is used to derive a correction to the total voltage amplitude measurement. However, another very useful procedure is to look for a voltage change of a predetermined fixed amplitude, while measuring the variable time to achieve that voltage change, and then using that time measurement to derive the appropriate correction.

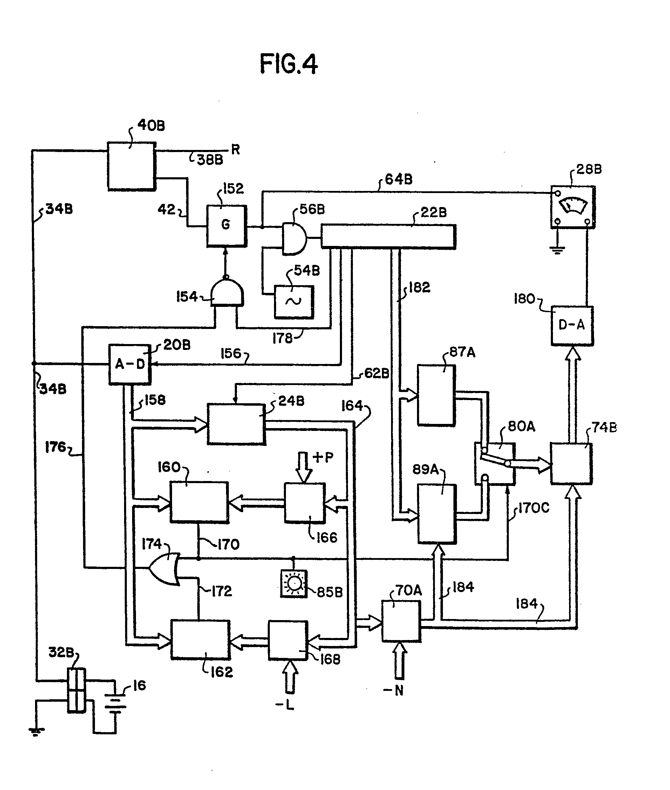

Fig. 4 is a schematic circuit diagram of another embodiment of the invention in which the time between a first voltage measurement and a second voltage measurement is variable, and is measured, until a predetermined voltage difference is achieved. The elapsed time is then used as a quantity for calculation of the appropriate correction for prediction of the steady state open circuit voltage and the determination of the state of charge.

In the embodiment of Fig. 4, components which are substantially identical to corresponding components in Fig. 3, or which perform similar functions, are given the same numbers as used in Fig. 3, but with the suffix letter B. The apparatus of Fig. 4 is preferably started when it is connected to the battery 16 by a connection device 32B, which may be of conventional construction. This results in the application of battery terminal voltage at connection 34B to an analog-to-digital converter 20B, and also to a delay circuit 40B, which may be a monostable multivibrator, sometimes referred to as a "single-shot" circuit. Delay circuit 40B is immediately "set", providing an output on connection 38B to reset all of the components of the circuit, the individual reset circuits not being illustrated. The setting of the delay circuit 40B initiates the timing of a delay interval, at the end of which the delay circuit resets, thus terminating the reset signal at 38B. Reset of delay circuit 40B also makes available a delayed signal on connection 42 which is supplied as an input to a gate 152, which is normally enabled by a NAND gate 154 to provide an output at connection 64B. The output at 64B disables the display device 28B, and enables an AND gate 56B. The enablement of AND gate 56B gates clock signals from a clock oscillator 54B into a counter 22B which serves as an elapsed time indicator, and also as a clock commutator control for the operation of the system.

The analog-to-digital converter 20B may be carried out in various ways. In one embodiment, it may include the voltage responsive variable frequency oscillator 18 of Fig. 3, the counter 20 of Fig. 3, and a timer such as counter 22 of Fig. 3 or it may employ timing connections (not shown) to the existing counter 22B of Fig. 4. At any rate, the analog-to-digital converter 20B is capable of taking the voltage signal available from battery 16 and converting that voltage signal to a digital quantity from time to time when enabled by a control signal pulse on connection 156 from the commutator control 22B. That digital quantity is then available on a data bus 158 to a storage register 24B and to two comparator circuits 160 and 162.

After the first analog-to-digital converter control pulse on connection 156, the commutator control 22B issued an enablement control pulse on a connection 62B to the register 24B, causing that register to read the number available upon the data bus 158 from the analog-to-digital converter 20B. That quantity, corresponding to the first voltage measurement, then remains stored in register 24B for the remainder of the operation of the apparatus for obtaining a particular reading at meter 28B. No more enabling pulses are emitted on connection 62B to register 24B during that operation of the apparatus. Accordingly, the quantity stored in 24B remains the same, and that quantity appears and continues to be available on an output bus 164.

The quantity appearing on the output bus 164 is incremented by a fixed factor P in an adder 166, and is compared in comparator 160 with new voltage readings from the analog-to-digital converter 20B appearing on bus 158. Concurrently, the first voltage reading quantity appearing on bus 164 is decremented by a fixed factor L in an adder 168, and is compared in comparator circuit 162 with the new voltage readings from the analog-to-digital converter 20B. The comparator 160 is operable to provide an output at an output connection 170 as soon as the condition is detected in which the latest number appearing on bus 158 from the analog-to-digital converter (representing the latest voltage reading) exceeds the incremented number from adder 166. This condition indicates a substantial match with a second point on one of the rising battery terminal voltage characteristics 6A, 7A, 8A, 9A, 11A, and 14A of Fig. 2. Similarly, comparator 162 is operable to provide an output signal on connection 172 when it first detects that the number on bus 158 is less than the number on bus 164 as decremented by factor L in adder 168. This is the condition which indicates a match with a second point on one of the decreasing voltage characteristic curves 1A—5A.

The factors P and L each represent a fixed voltage difference between a first reading and a second reading which is to be detected by the compare circuits 160 and 162. P and L may be equal in magnitude, but not necessarily. The negative slope curves 1A through 5A have a greater slope than do the positive slope curves 6A et seq. Therefore, the factor L, which is used to recognize negative slopes, may be selected to be somewhat smaller than the factor P which is used to recognize positive slopes, since a significant measureable value will be available in a shorter time with the negative slopes. On the other hand, if it is desired to have the remainder of the circuits work in a more symmetrical manner, with similar elapsed times being used for corrections, then L may be selected to be larger than P, so that the times to achieve the fixed change in voltage may be comparable for the negative slope curves and the positive slope curves.

If either of the outputs on 170 or 172 from the comparators 160 and 162 is available, then the OR gate 174 is activated to provide a logic 1 output signal on connection 176 as an input to NAND gate 154. NAND gate 154 is also provided with a clock signal on connection 178 after each operation of the analog-to-digital converter 20B. Accordingly, as soon as an operation of the analog-to-digital converter 20B results in an output from one of the comparators 160 or 162, the next succeeding commutation signal to NAND gate 154 on connection 178 results in a logic zero output from NAND gate 154. This disables gate 152, resulting in the disablement of AND gate 56B so as to stop counter 22B. The disablement of gate 152 also removes the disablement signal on connection 64B to the meter 28B, so that the apparatus may indicate the state of charge.

The state of charge is derived from the circuitry now to be described. The initial voltage measurement number appearing on bus 164 is supplied to an adder 70A. In adder 70A, a factor N is subtracted from the number to provide the "zero" correction so that the meter 28B may read on an expanded scale basis to show zero for fully discharged and full scale for fully charged. The quantity from adder 70A is then transmitted to an adder 74B which provides a correction function based on the voltage difference measurement. That function is added through data switch 80A. After the addition of that correction function, the data is transferred to a data converter 180 to convert the data to a form which is usable by the meter 28B. The data converter 180 may be a digital-to-analog converter if the meter is an analog meter, as shown, or the converter 180 may be a digital converter for converting the data to a digital form for use by an indicator. Such a form may be a seven segment code for energizing a decimal digit readout device, or a one out of N code converter for providing a digital display which simulates a moving pointer.

The correction factors provided through switch 80A are from correction transform circuits 87A and 89A, and are based upon elapsed time measurements available from the elapsed time counter 22B on a bus 182. Recognition of whether the curve matching by the operation of the comparators 160 and 162 was accomplished for a positive voltage difference by comparator 160, or for a negative voltage difference by comparator 162, is accomplished by means of an extension 170C of the output line 170 from the positive comparator 160 to switch 80A. The resultant enablement of the switch 80A causes the switch to connect the positive correction transform device 87A through to the adder 74B. Otherwise, the switch 80A is normally in the position to connect the negative transform circuit 89A to the adder 74B. It will be appreciated that switch 80A is only schematically shown, as it will typically be an electronic digital switch which may include a number of logic gates.

Since the characteristics, as plotted in Fig. 2, are substantially logarithmic functions of time, the correction transform circuits 87A and 89A each generate signals which are representative of an inverse anti-logarithmic function of the elapsed time from the first measurement to the second measurement. The elapsed time signal is supplied on connection 182 to each of these transform circuits. The function generated by each transform circuit is an inverse function because a greater elapsed time required for the predetermined voltage difference to develop indicates that the battery has been in a quiescent state for a longer interval, and it's closer to the steady state open circuit condition so that a smaller correction is required to provide the correct output.

As explained in connection with Fig. 3, since the negative slope curves 1A et seq have different slopes, at different states of charge, that situation must be accommodated by providing the zero corrected first voltage reading number from the adder 70A through connection 184 to the correction transform circuit 89A so that the voltage level may be factored in which a computation comparable to that carried out with the adder 142 and the variable gain amplifier 89 of Fig. 3.

The lowest order stages of the counter 22B may be used for the clock commutator control of the operations of the converter 20B by the timing pulse on connection 156, and for testing to see if a comparison output is available by means of the timing pulse on connection 178 to the NAND gate 154. Thus, each time the counter 22B is incremented, a new comparison may be made and checked. However, since time is essentially a logarithmic function in the curves which are to be matched, as the elapsed time becomes longer, it is not necessary to have equally time spaced tests for comparison. Furthermore, if the timing counter 22B is made to count up in a logarithmic progression of counts, then the output at bus 182 to the transform circuits 87A and 89A is an antilog function, and the transform function circuits may then be simplified. Accordingly, an alternative arrangement for the circuit of Fig. 4 is to provide for a logarithmic time function advance of the counter 22B. This can be accomplished in various ways by providing for progressively increasing time spacing between successive pulses from the clock 54B. One very useful method is to provide a pulse divider circuit between the clock oscillator 54B and the AND gate 56B in which the division factor is variable and controlled by the accumulated count in the counter 22B.

In the system of Fig. 4, temperature may be measured, and temperature compensation signals incorporated, as discussed above in connection with Fig. 3. However, the temperature compensation input signals are not indicated in Fig. 4.

The embodiment of Fig. 3, in which the voltage difference is measured over a fixed interval of time, provides the best results when used in the earlier portions of the quiescent battery interval when the voltage changes per unit of time are high. The embodiment of Fig. 4, in which the time is measured for a predetermined fixed change in voltage, provides better resolution when the test is made later in the quiescent interval when the changes in terminal voltage are less rapid. If the Fig. 3 embodiment is used in the low slope regions of the quiescent interval, the difference in voltage over the fixed interval of time may be so small that it is very difficult to measure. On the other hand, the system of Fig. 4 provides less resolution in the steep slope operating regions.

In one useful modification, the systems of Fig. 3 and Fig. 4 may be combined, the operation of both systems being started simultaneously. If, at the end of the fixed time interval, the difference voltage detected by the remainder in counter 20 of the Fig. 3 system is very small, or not measurable, then the system at Fig. 4 is operable to measure for a fixed voltage difference over a variable time interval. In this manner, a combined system makes use of the advantages of both of the systems of Figs. 3 and 4. In such a combined system, each of the individual systems of Figs. 3 and 4 preferably operate independently of one another, and preferably share a common output meter, with simple logic gates which permit only the first of the two systems which comes up with a meaningful output to take possession of the output meter and place its output on that meter. In the instance given above, where the remainder in counter 20 of the Fig. 3 system is very small, or not measurable, then the system of Fig. 3 would lock itself out so that only the system of Fig. 4 would ultimately register an output on the meter.

In such a combined system of Figs. 3 and 4, it is also possible to select a fixed time interval for the Fig. 3 portion of the combined system, and a fixed voltage difference for the Fig. 4 portion of the system such that there will be instances during very high curve slope detection when the fixed voltage difference condition will be satisfied before the fixed time interval has elapsed. In this instance, the Fig. 4 portion of the combined system will take possession of the output meter to the exclusion of the Fig. 3 portion. The advantage of such a system is that a reading is obtained very quickly.

In still another modification, two sets of Fig. 3 apparatus may be employed, having two different fixed time intervals. If, at the end of the shorter fixed time interval, the difference voltage detected by the remainder in counter 20 is very small, or not measurable, then the second Fig. 3 apparatus, providing a longer time interval, is switched in and becomes operative. In this same manner, more than two fixed time intervals may be employed until a reading of sufficient significance is obtained.

In the description of the systems of both Figs. 3 and 4, two voltage measurements are made, the voltage difference is measured, and the state of charge is computed on the basis of the first of the two voltage measurements together with the voltage difference. It will be quite apparent that it is possible to compute the state of charge based upon the voltage difference plus the second voltage measurement, since the value of the voltage does not change significantly except in terms of the difference measurement.

Furthermore, the description of the invention is given entirely in terms of measuring a single voltage difference between one pair of points in time. It will be apparent, however, that the method and apparatus of the invention can be easily expanded to provide for a series of measurements of voltage differences, and for crosschecking from one voltage difference measurement to another to verify the correctness of the measurements in order to enhnace the accuracy.

As stated above, both of the embodiments of Figs. 3 and 4 are schematic representations. It will be understood that additional components such as logic gates may be desirable in order to refine the operations of these circuits and to prevent problems such as undesired back circuits. Also, power supplies, voltage scaling circuits, and other refinements are not shown.

It will be understood that the quiescent voltage recovery characteristics given in Figs. 1 and 2 are typical characteristics for some lead acid system batteries. However, other batteries may display other quiescent voltage recovery characteristics, and adjustments in the functions provided by the function generators 87 and 89 of Fig. 3 may be made to accommodate to those other characteristics. In particular, if the other quiescent voltage recovery characteristics display a high degree of parallelism in the recovery from the charge mode, for instance, then a function generator similar to the function generator 87 may be used for the function generator 89, without the multiplication function. Similarly, if such other voltage characteristics provide a substantial divergence in the recovery curves from the discharge condition, then the correction function generator 87 may be replaced by a function generator similar to function generator 89, incorporating a multiplication function.

As explained above in connection with Fig. 3, the correction function generator 89 operates by multiplication of a factor corresponding to the voltage obtained from register 24 through digital-to-analog converter 66 after modification in the subtractor 70 and the adder 142. The subtractor 70 subtracts one factor, and the adder 142 adds another factor. Therefore, the signal at the output from adder 142 at connection 144 represents the voltage level signal, with what may be characterized as a "zero level adjustment", to provide a zero level adjusted value of the voltage level.

In Fig. 3, it was stated that when the remainder reading in counter 20 was either zero or 1, and thus too low to activate either of the logic networks 26 or 30, the remainder reading was regarded as being substantially indeterminate. While not illustrated in the drawing, it may be desirable to provide gates and a visual indicator actuated by such gates to indicate that condition to the operator, so that the operator will be aware that the accuracy of the instrument may be impaired by the low resolution reading.

In the operation of the system of Fig. 4, if the slope of the recovery curve is very low, as it is in the later stages of recovery, quite a long interval may be required to achieve the fixed voltage difference at which the second voltage measurement is taken. Accordingly, while not shown, a desirable added feature for the system of Fig. 4 is a time-out switching feature which causes the meter to register the zero corrected first voltage measurement supplied through the subtractor 70A, without the addition of a correction factor in adder 74B, after a considerable interval has elapsed without the achievement of the fixed voltage difference. This assumes that the slope of the recovery curve is so low that the difference between the first voltage measurement and steady state battery terminal voltage is inconsequential.

The above description of the operation of the system assumes that the battery is in good condition. However, if the condition of the battery is impaired, such that there is a weak or dead cell, for instance, the instrument will register a low charge condition. The fewer cells there are in the system, the lower the reading will be.

## Claims

1. A quiescent battery testing method for testing a battery (16, Fig. 3) which is not connected to a load or to a charging source comprising the steps of taking a first battery terminal voltage measurement (at 18, 20), noting said first measurement (at 20, 24), and characterized by taking a second terminal voltage measurement (at 20) at a subsequent time, and comparing said second measurement with said first measurement (at 78) to determine the direction of voltage change from said first measurement to said second measurement as a basis for determining whether the battery was last subjected to charge or discharge.

2. A method as claimed in claim 1 further characterized by the steps of measuring the time interval (at 22) from the first battery terminal voltage measurement to the second battery terminal voltage measurement and comparing said second voltage measurement with said first voltage measurement (at 26, 30) in relation to the time interval measurement to determine the rate of voltage change from said first voltage measurement to said second voltage measurement, and then using the combination of the value of one of said voltage measurements (at 24) and the direction and the rate of voltage change (26, 30) to determine a quantity (87, 89, 74, 28) which is a function of a predicted steady-state open circuit voltage as a determination of the battery state-of-charge.

3. A method as claimed in claim 2 further characterized in that the determination of the quantity which is a function of a predicted steady state open circuit voltage is based upon known battery terminal voltage recovery characteristics after a battery current exchange for the type of battery under test.

4. A method as claimed in claim 2 further characterized in that said measured time interval between said first measurement and said second measurement is a fixed time interval.

5. A method as claimed in claim 4 further characterized in that the following additional step is taken when said second measurement after a fixed time interval does not provide a difference from said first measurement sufficient for an accurate difference determination: taking another second voltage measurement at the end of a longer fixed time interval after said first voltage measurement.

6. A method as claimed in claim 4 further characterized in that the following additional step is taken when said second measurement after a fixed time interval does not provide a difference from said first measurement sufficient for an accurate difference determination comprising taking another second voltage measurement at the end of a variable time interval after said first voltage measurement which is determined at a second voltage measurement which represents a predetermined fixed difference from said first voltage measurement.

7. Apparatus for testing a quiescent battery comprising means (18, 20; Fig. 3) for taking battery terminal voltage measurements, means (20, 24) for storing a first battery terminal voltage measurement, characterized by means (78) for comparing a second battery terminal voltage measurement taken at a subsequent time with said first battery terminal voltage measurement and operable to determine the direction of voltage change of said second voltage measurement from said stored first voltage measurement and to generate at least one signal indicating the direction of voltage change, and visual indicating means (85) connected to said comparison means (78) to receive said direction of voltage change signal for providing a visual indication of the direction of voltage change as an indication as to whether the battery was last subjected to charge or discharge.

8. Apparatus as claimed in claim 7 further characterized in the provision of means (22) for measuring the time interval from the first battery terminal voltage measurement to the second battery terminal voltage measurement, means (26, 30) for comparing said second voltage measurement with said first voltage measurement in relation to the time interval measurement to generate a quantity corresponding to the rate of voltage change from said first voltage measurement to said second voltage measurement, means (70, 74, 87, 89, 80) connected to receive one of said voltage measurements and said rate of voltage change quantity and said direction of voltage change signal (at 78) and operable to determine a quantity which is a function of a predicted steady-state open circuit voltage as a determination of the battery state-of-charge, and display means (28) connected to said last-named means for display of said state-of-charge quantity.

9. Apparatus as claimed in claim 8 further characterized in that said means (22) for measuring said time interval is operable to measure a fixed time interval, and said battery terminal voltage measurement means comprises a voltage controlled oscillator (18) connected (34, 32) to receive the voltage (16) to be measured and a reversible counter (20) operable to count the number of oscillations from the voltage controlled oscillator, said counter (20) being operable to count in one direction over a fixed interval of time to take said first voltage measurement, said counter (20) being operable to reverse to count in the other direction to make said second voltage measurement so that any residue count remaining in the counter represents the difference between the two voltage measurements.

10. Apparatus as claimed in claim 8 further characterized in that said means (160, 162; Fig. 4) for comparing said second voltage measurement (at 158) with said first voltage measurement (at 24B) is operable to determine a second voltage measurement which represents a predetermined fixed voltage difference (P at 166, L at 168) from said first voltage measurement.

11. Apparatus as claimed in claim 10 further characterized in that said comparison means (160, 162) comprises at least one comparison circuit (160) connected to compare successive voltage measurements (at 158) with the sum (at 166) of the stored first voltage measurement (at 24B) and a fixed difference voltage quantity (P) to determine when one of the successive voltage measurements more than matches the sum.

12. Apparatus as claimed in claim 8 further characterized in that said means (70, 74, 87, 89, 80) for determining the quantity which is a function of a predicted steady state open circuit voltage comprises means (74) for adding a factor to one of said voltage measurements, and means (20, 26, 30, 87, 89) for determining said last-named factor as a function of the rate of change between said voltage measurements.

13. Apparatus as claimed in claim 12 further characterized in that said factor determining means (87, 89) is operable to determine said last-named factor as a substantially anti-logarithmic function of voltage change per unit of time.

14. Apparatus as claimed in claim 12 further characterized in that said means (20, 26, 30, 87, 89) for determining said factor as a function of the rate of change between said voltage measurements comprises a digital counter (20) for storing a number corresponding to said voltage change and logic gates (26, 30) connected to said counter (20) and operable to determine different ranges of values for said rate of change, and at least one correction function generator (87, 89) connected to said logic gates (30, 26) and operable in response to the determination of the ranges of values (at 100—106) for said rate of change to provide a value for said factor based upon the determined voltage change rate range.

15. Apparatus as claimed in claim 14 further characterized in that said means (20, 26, 30, 87, 89) for determining said factor as a function of the rate of change between said voltage measurements further includes an adder circuit (142), said adder circuit being connected to receive one of said voltage measurements (from 24, 66, 70) and to add a fixed quantity (M) to said voltage measurement to provide a zero level adjusted voltage measurement, and further characterized in that said correction function generator (89) comprises a multiplier circuit connected (144) to receive the zero level adjusted voltage measurement from said adder (142), said multiplier (89) being operable to multiply said zero level adjusted voltage measurement by different selected factors as selected by said different voltage change rate ranges (at 126—132) to thereby generate a product output (86) as said factor determined as a function of the rate of change between said voltage measurements.

16. Apparatus as claimed in claim 7 further characterized in that said means (18, 20) for taking battery terminal voltage measurements comprises a voltage controlled oscillator (18) and a digital counter (20) connected to receive oscillation pulses from said voltage controlled oscillator (18) for counting those pulses as a measurement of voltage, said means for comparing a second battery terminal voltage measurement taken at a subsequent time comprising means (48, 52) for reversing the operation of said reversible counter (20) during said second battery terminal voltage measurement to count said counter in the reverse direction, and said means for comparing said second battery terminal voltage with said first battery terminal voltage measurement including means (78) to determine whether or not said reversible counter is switched into the complement mode to indicate a negative remainder in said reversible counter as an indication of the direction of voltage change.

17. Apparatus as claimed in claim 12 further characterized in the provision of means (70) for subtracting a fixed factor from said one of said voltage measurements to provide for a zero corrected indication of state of charge upon said display means (28).

18. Apparatus as claimed in claim 8 further characterized in the provision of a temperature measurement means (146, 148, 150) connected to said predicted steady state open circuit voltage function means (70, 87, 89) to modify the operation of said last named means to compensate for temperature changes.

19. Apparatus as claimed in claim 8 further characterized in that said means for measuring the time interval from the first battery terminal voltage measurement to the second battery terminal measurement comprises a digital counter (22) and a timing oscillator (54), the lower order stages of said digital counter (22) being operable to provide clock commutator switching functions for said apparatus.

**Patentansprüche**

1. Leerlaufbatterie-Prüfverfahren zum Prüfen einer Batterie (16, Fig. 3), die nicht mit einer Last oder einer Ladequelle verbunden ist, bei dem eine erste Batterieklemmenspannungsmessung (an 18, 20) durchgeführt und der Meßwert der erähnten ersten Messung (an 20, 24) festgehalten wird, dadurch gekennzeichnet, daß eine zweite Klemmenspannungsmessung (an 20) zu einem späteren Zeitpunkt durchgeführt und der Meßwert der erwähnten zweiten Messung mit dem Meßwert der erwähnten ersten Messung (an 78) verglichen wird, um die Richtung der Spannungsänderung von der erwähnten ersten Messung zu der erwähnten zweiten Messung festzustellen, und zwar als Basis für die Feststellung, ob die Batterie zuletzt geladen oder entladen wurde.

2. Verfahren nach Anspruch 1, ferner gekennzeichnet durch Messung der Zeitspanne (an 22) von der ersten Batterieklemmenspannungsmes-sung bis zur zweiten Batterieklemmenspannungs-messung und Vergleichen des Meßwerts der erwähnten zweiten Spannungsmessung mit dem Meßwert der erwähnten ersten Spannungsmessung (an 26, 30) in Relation zur Zeitspannenmessung, um die Geschwindigkeit der Spannungsänderung von der erwähnten ersten Spannungsmessung zur erwähnten zweiten Spannungsmessung festzustellen, und dann Benutzung der Kombination des Meßwerts der einen der erwähnten Spannungsmessungen (an 24) und der Richtung und der Geschwindigkeit der Spannungsänderung (26, 30) der Bestimmung einer Größe (87, 89, 74, 28), die eine Funktion einer vorausgesagten Stationärzustands-Leerlaufspannung als eine Feststellung des Batterie-Ladezustands ist.

3. Verfahren nach Anspruch 2, ferner dadurch gekennzeichnet, daß die Bestimmung der Größe, die eine Funktion einer vorausgesagten Stationärzustands-Leerlaufspannung ist, auf einer bekannten Batterieklemmenspannungswiederherstellungskennlinie nach einem Batteriestromaustausch für den Typ der in der Prüfung befindlichen Batterie basiert.

4. Verfahren nach Anspruch 2, ferner dadurch gekennzeichnet, daß die erwähnte gemessene Zeitspanne zwischen der erwähnten ersten Messung und der erwähnten zweiten Messung eine feste Zeitspanne ist.

5. Verfahren nach Anspruch 4, ferner dadurch gekennzeichnet, daß zusätzlich, wenn die erwähnte zweite Messung nach einer festen Zeitspanne keine für eine genaue Differenzbestimmung hinreichende Differenz gegenüber der erwähnten ersten Messung ergibt, am Ende einer längeren festen Zeitspannen nach der erwähnten ersten Spannungsmessung eine weitere zweite Spannungsmessung durchgeführt wird.

6. Verfahren nach Anspruch 4, ferner dadurch gekennzeichnet, daß zusätzlichen, wenn die erwähnte zweite Messung nach einer festen Zeitspanne keine für eine genaue Differenzbestimmung hinreichende Differenz gegenüber der erwähnten ersten Messung ergibt, eine weitere zweite Spannungsmessung durchgeführt wird, und zwar am Ende einer veränderbaren Zeitspannen nach der erwähnten ersten Spannungsmessung, die bei einer zweiten Spannungsmessung bestimmt wird, die eine vorbestimmte feste Differenz gegenüber der erwähnten ersten Spannungsmessung darstellt.

7. Vorrichtung zum Prüfen einer leerlaufenden Batterie mit einem Mittel (18, 20; Fig. 3) zur Durchführung von Batterieklemmenspannungs - messungen und einem Mittel (20, 24) zum Speichern des Meßwerts einer ersten Batterieklemmenspannungsmessung, gekennzeichnet durch ein Mittel (78) zum Vergleichen des Meßwerts einer zu einem späteren Zeitpunkt durchgeführten zweiten Batterieklemmenspannungsmessung mit dem Meßwert der erwähnten ersten Batterieklemmenspannungsmessung, das derart betreibbar ist, daß es die Richtung der Spannungsänderung von dem gespeicherten Meßwert der erwähnten ersten Spannungsmessung der erwähnten zweiten Spannungsmessung bestimmt und wenigstens ein Signal erzeugt, das die Richtung der Spannungsänderung anzeigt, und ein Sichtanzeigemittel (85), das an das erwähnte Vergleichsmittel (78) angeschlossen ist, um das erwähnte Spannungsänderungsrichtungssignal aufzunehmen und eine Sichtanzeige der Richtung der Spannungsänderung als Anzeige dafür zu bewirken, ob die Batterie zuletzt geladen oder entladen wurde.

8. Vorrichtung nach Anspruch 7, gekennzeichnet durch ein Mittel (22) zum Messen der Zeitspanne zwischen der ersten Batterieklemmenspannungsmessung und der zweiten Batterieklemmenspannungsmessung, ein Mittel (26, 30) zum Vergleichen des Meßwerts der erwähnten zweiten Spannungsmessung mit dem Meßwert der erwähnten ersten Spannungsmessung in Relation zur Zeitspannenmessung, um eine der Geschwindigkeit der Spannungsänderung von der erwähnten ersten Spannungsmessung bis zur erwähnten zweiten Spannungsmessung entsprechende Größe zu erzeugen, ein Mittel (70, 74, 87, 89, 80), das so angeschlossen ist, daß es den Meßwert einer der erwähnten Spannungsmessungen und die erwähnte Spannungsänderungsgeschwindigkeit sowie das erwähnte Spannungsänderungsrichtungssignal (an 78) aufnimmt, und das derart betreibbar ist, daß es eine Größe bestimmt, die eine Funktion einer vorausgesagten Stationsärzustands-Leerlaufspannung ist, um den Batterieladezustand festzustellen, und ein Anzeigemittel (28), das an das zuletzt erwähnte Mittel zur Anzeige der erwähnten Ladezustandsgröße angeschlossen ist.

9. Vorrichtung nach Anspruch 8, ferner dadurch gekennzeichnet, daß das erwähnte Mittel (22) zum Messen der erwähnten Zeitspanne derart betreibbar ist, daß es eine feste Zeitspanne mißt, daß das erwähnte Batterieklemmenspannungsmeßmittel einen spannungsgesteuerten Oszillator (18), der so angeschlossen ist (34, 32), daß er die zu messende Spannung (16) erhält, und einen reversierbaren Zähler (20) aufweist, der derart betreibbar ist, daß er die Anzahl der Schwingungen des spannungsgesteuerten Oscillators zählt, daß der erwähnte Zähler (20) derart betreibbar ist, daß er in der einen Richtung während einer festen Zeitspanne zählt, um die erwähnte erste Spannungsmessung durchzuführen, und daß der erwähnte Zähler (20) derart betreibbart ist, daß er die Zählrichtung umkehrt, um die erwähnte zweite Spannungsmessung durchzuführen, so daß ein in dem Zähler verbleibender Restzählwert die Differenz zwischen den Meßwerten der beiden Spannungsmessungen darstellt.

10. Vorrichtung nach Anspruch 8, ferner dadurch gekennzeichnet, daß das erwähnte Mittel (160, 162; Fig. 4) zum Vergleichen des Meßwerts der erwähnten zweiten Spannungsmessung (an 158) mit dem Meßwert der erwähnten ersten Spannungsmessung (an 24B) derart betreibbar ist, daß es einen zweiten Spannungsmeßwert bestimmt, der eine vorbestimmte feste Spannungsdifferenz (P an 166, L an 168) gegenüber dem Meßwert der erwähnten ersten Spannungsmessung darstellt.

11. Vorrichtung nach Anspruch 10, ferner dadurch gekennzeichnet, daß das erwähnte Vergliechsmittel (160, 162) wenigstens eine Vergleichsschaltung (160) aufweist, die so angeschlossen ist, daß sie die Meßwerte aufeinanderfolgender Spannungsmessungen (an 158) mit der Summe (an 166) aus dem gespeicherten Meßwert der ersten Spannungsmessung (an 24B) und einer festen Differenzspannungsgröße (P) vergleicht, um zu bestimmen, wann der Meßwert einer der aufeinanderfolgender Spannungsmessungen der Summe mehr als entspricht.

12. Vorrichtung nach Anspruch 8, ferner dadurch gekennzeichnet, daß das erwähnte Mittel (70, 74, 87, 89, 80) zum Bestimmen der Größe, die eine Funktion einer vorausgesagten Stationärzustands-Leerlaufspannung ist, ein Mittel (74) zum Addieren eines Faktors zum Meßwert einer der erwähnten Spannungsmessungen und ein Mittel (20, 26, 30, 87, 89) zum Bestimmen des zuletzt erwähnten Faktors als eine Funktion der Änderungsgeschwindigkeit zwischen den erwähnten Spannungsmessungen aufweist.

13. Vorrichtung nach Anspruch 12, ferner dadurch gekennzeichnet, daß das erwähnte Faktorbestimmungsmittel (87, 89) derart betreibbar ist, daß es den zuletzt erwähnten Faktor als eine im wesentlichen antilogarithmische (Numerus-) Funktion der Spannungsänderung pro Zeiteinheit bestimmt.

14. Vorrichtung nach Anspruch 12, ferner dadurch gekennzeichnet, daß das erwähnte Mittel (20, 26, 30, 87, 89) zum Bestimmen des erwähnten Faktors als eine Funktion der Geschwindigkeit der Änderung zwischen den erwähnten Spannungsmessungen einen digitalen Zähler (20) zum Speichern einer Zahl, die der erwähnten Spannungsänderung entspricht, logische Verknüpfungsglieder (26, 30), die an den erwähnten Zähler (20) angeschlossen und derart betreibbar sind, daß sie verschiedene Wertebereiche der erwähnten Änderungsgeschwindigkeit bestimmen, und mindestens einen Korrekturfunktionsgenerator (87, 89) aufweist, der an die erwähnten logischen Verknüpfungsglieder (30, 26) angeschlossen und derart betreibbar ist, daß er in Abhängigkeit von der Bestimmung der Wertebereiche (an 100—106) der erwähnten Änderungsgeschwindigkeit einen Wert für den erwähnten Faktor auf der Basis des bestimmten Spannungsänderungsgeschwindig - keitsbereiches erzeugt.

15. Vorrichtung nach Anspruch 14, ferner dadurch gekennzeichnet, daß das erwähnte Mittel (20, 26, 30, 87, 89) zum Bestimmen des erwähnten Faktors als eine Funktion der Geschwindigkeit der Änderung zwischen den erwähnten Spannungsmessungen ferner eine Addierschaltung (142) aufweist, die so angeschlossen ist, daß sie den Meßwert einer der erwähnten Spannungsmessungen (von 24, 66, 70) erhält und eine feste Größe (M) zu dem Meßwert der erwähnten Spannungsmessung addiert, um eine auf null bezogene Spannungsmessung zu bewirken, und ferner dadurch gekennzeichnet, daß der erwähnte Korrekturfunktionsgenerator (89) eine Multiplizierschaltung aufweist, die so angeschlossen (144) ist, daß sie den auf null bezogenen Spannungsmeßwert aus dem erwähnten Addierer (142) erhält, wobei die erwähnte Multiplizierschaltung (89) derart betreibbar ist, daß sie den erwähnten auf null bezogenen Spannungsmeßwert mit verschiedenen in Abhängigkeit von den erwähnten verschiedenen Spannungsänderungsgeschwin - digkeitsbereichen (an 126—132) ausgewählten Faktoren multipliziert, um eine Produktausgangsgröße (36) als den erwähnten Faktor zu erzeugen, der als Funktion der Geschwindigkeit der Änderung zwischen der erwähnten Spannungsmes - sung bestimmt ist.

16. Vorrichtung nach Anspruch 7, ferner dadurch gekennzeichnet, daß das erwähnte Mittel (18, 20) zur Durchführung von Batterieklemmenspannungsmessungen einen spannungsgesteu - erten Oszillator (18) und einen digitalen Zähler (20) aufweist, der so angeschlossen ist, daß er Schwingungsimpulse des erwähnten spannungsgesteuerten Oszillators (18) zum Zählen dieser Impulse als Maß für die Spannung erhält, daß das erwähnte Mittel zum Vergleichen des Meßwerts einer zweiten Batterieklemmenspannungsmes - sung, die zu einem späteren Zeitpunkt durchgeführt wurde, ein Mittel (48, 52) zum Umkehren des Betriebs des erwähnten reversiblen Zählers (20) während der erwähnten zweiten Batterieklemmenspannungsmessung, so daß der Zähler in umgekehrter Richtung zählt, aufweist, und das erwähnte Mittel zum Vergleichen des Meßwerts der erwähnten zweiten Batterieklemmenspan - nungsmessung mit dem Meßwert der erwähnten ersten Batterieklemmenspannungsmessung ein Mittel (78) zum Feststellen, ob der reversible Zähler auf den Komplementärbetrieb umgeschaltet ist, um einen negativen Rest in dem erwähnten reversiblen Zähler als Anzeige der Spannungsänderungsrichtung anzuzeigen, aufweist.

17. Vorrichtung nach Anspruch 12, ferner gekennzeichnet durch ein Mittel (70) zum Substrahieren eines festen Faktors vom Meßwert der erwähnten einen der erwähnten Spannungsmessungen, um für eine nullpunktskorrigierte Anzeige des Ladezustands auf dem erwähnten Anzeigemittel (28) zu sorgen.

18. Vorrichtung nach Anspruch 8, ferner gekennzeichnet durch ein Temperaturmeßmittel (146, 148, 150), das an das erwähnte Voraussage-Stationärzustands - Leerlaufspannungsfunktionsmittel (70, 87, 89) angeschlossen ist, um den Betrieb das zuletzt erwähnten Mittels so zu ändern, daß Temperaturänderungen kompensiert werden.

19. Vorrichtung nach Anspruch 8, dadurch gekennzeichnet, daß das erwähnte Mittel zum Messen der Zeitspanne zwischen der ersten Batterieklemmenspannungsmessung und der zweiten Batterieklemmenspannungsmessung einen digitalen Zähler (22) und einen Taktoszillator (54) aufweist und die niedrigeren Stellen des erwähnten digitalen Zählers (22) derart betreibbar sind, daß sie Taktgeberkomutatorumschaltfunktionen für die erwähnte Vorrichtung bewirken.

**Revendications**

1. Méthode pour tester une batterie (16, Fig. 3) au repos, qui n'est pas connecté à une charge ou à une source de charge, comprenant les étapes de prendre d'abord une première mesure (à 18, 20) de la tension aux bornes de la batterie, de prendre note (à 20, 24) de cette première mesure, et caractérisée en ce qu'on prend une deuxième mesure (à 20) de la tension aux bornes de la batterie à une moment subséquent et qu'on compare (à 78) cette seconde mesure avec la première mesure pour déterminer la direction de changement de la tension de la première mesure à la seconde mesure comme base pour déterminer si la batterie a été soumiseen dernier lieu à une charge ou une décharge.

2. Méthode selon la revendication 1, caractérisé en outre par les étapes de mesurer (à 22) l'intervalle de temps entre la première mesure de la tension aux bornes de la batterie et la seconde mesure de la tension aux bornes de la batterie et de comparer (à 26, 20) la seconde mesure de la tension avec la première mesure de la tension en rapport avec la mesure de l'intervalle de temps pour déterminer la vitesse de variation de la tension entre la première mesure de la tension et la seconde mesure de la tension et d'utiliser ensuite la combinaison de la valeur d'une des mesures de la tension (à 24) et la direction et la vitesse de variation de la tension (26, 30) pour déterminer une grandeur (87, 89, 74, 28) qui est une fonction d'une tension en régime permanent à circuit ouvert prédite comme détermination de l'état de charge de la batterie.

3. Méthode selon la revendication 2, caractérisé en outre en ce que la détermination de la grandeur qui est une fonction de la tension de régime permanent à circuit ouvert prédite est basée sur les caractéristiques de récupération connues de la tension aux bornes de la batterie après échange de courant de la batterie pour le type de batterie sous essai.

4. Méthode selon la revendication 2, caractérisée en outre en ce que ledit intervalle de temps mesuré entre la première et la seconde mesure est un intervalle de temps fixe.

5. Méthode selon la revendication 4, caractérisée en outre en ce que l'étape suivante supplémentaire est exécutée, quand la seconde mesure faite après un intervalle de temps fixe ne fournit pas une différence suffisante par rapport à la première mesure pour une détermination exacte de la différence: faire une autre seconde mesure de tension à la fin d'un intervalle de temps fixe plus long après la première mesure de la tension.

6. Méthode selon la revendication 4, caractérisée en outre en ce que l'étape supplémentaire suivant est exécutée, quand la seconde mesure faite après un intervalle de temps fixe ne fournit pas une différence par rapport à la première mesure suffisante pour une détermination exacte de la différence, cette étape supplémentaire consistant à prendre une seconde mesure de la tension à la fin d'un intervalle de temps variable après la première mesure de tension qui est déterminé pour une seconde mesure de tension qui représente une differérence fixe prédéterminée par rapport à la première mesure de la tension.

7. Appareil pour tester une batterie au repos comprenant des moyens (18, 20; Fig. 3) pour faire des mesures de la tension aux bornes de la batterie, des moyens (20, 24) pour mémoriser une première mesure de la tension aux bornes de la batterie, caractérisé par des moyens (78) pour comparer une seconde mesure de la tension aux bornes de la batterie prise à un moment subséquent avec la première mesure de la tension aux bornes de la batterie et fonctionnant pour déterminer la direction de la variation de la tension de la seconde mesure de la tension par rapport à la première mesure de la tension mémorisée et pour produire au moins un signal indiquant la direction du changement de la tension, et un moyen d'indication visuel (85) connecté au moyen comparateur (78) pour recevoir ledit signal de changement de direction de la tension pour fournir une indication visuelle de la direction de changement de la tension pour indiquer si la batterie a été soumise en dernier lieu à une charge ou à une décharge.

8. Appareil selon la revendication 7, caractérisé en outre par un moyen (22) pour mesurer l'intervalle de temps entre la première mesure de la tension aux bornes de la batterie et la seconde mesure de la tension aux bornes de la batterie, des moyens (26, 30) pour comparer cette seconde mesure de la tension avec la première mesure de la tension en rapport avec la mesure de l'intervalle de temps pour fournir une grandeur correspondant à la vitesse de variation de la tension entre la première mesure de la tension et la seconde mesure de la tension, des moyens (70, 74, 87, 89, 80) connectés pour recevoir une des mesures de la tension et la grandeur indiquant la vitesse de variation de la tension et le signal indiquant la direction de changement de la tension (à 78) et fonctionnant pour déterminer une grandeur qui est une fonction d'une tension de régime permanent à circuit ouvert prédite comme détermination de l'état de charge de la batterie et des moyens d'affichage (28) connectés au dernier moyen nommé pour afficher la grandeur d'état de charge.

9. Appareil selon la revendication 8, caractérisé en outre en ce que le moyen (22) pour mesurer l'intervalle de temps fonctionne pour mesurer un intervalle de temps fixe et que les moyens de mesure de la tension aux bornes de la batterie comprennent un oscillateur (18) commandé par la tension connecté (34, 32) pour recevoir la tension (16) à mesurer et un compteur réversible (20) fonctionnant pour compter le nombre d'oscillations de l'oscillateur commandé par la tension, ledit compteur (20) pouvant fonctionner pour compter dans une direction pendant un intervalle de temps fixe pour prendre la première mesure de tension, ledit compteur (20) pouvant fonctionner pour renverser le comptage dans l'autre direction pour faire la seconde mesure de la tension de sorte que tout reste de comptage restant dans le compteur représente la différence entre les deux mesures de la tension.

10. Appareil selon la revendication 8, caractérisé en outre en ce que le moyen (160, 162; Fig. 4) pour comparer la seconde mesure de la tension (à 158) avec la première mesure de la tension (à 24B) fonctionne pour déterminer une seconde mesure de la tension qui représente une difference de tension fixe prédéterminée (P à 166, L à 168) par rapport à la première mesure de la tension.

11. Appareil selon la revendication 10, caractérisé en outre en ce que le moyen de comparaison (160, 162) comprend au moins un circuit de comparaison (160) connecté pour comparer des mesures de tension successives (à 158) avec la somme (166) de la première mesure de tension mémorisée (à 24B) et une grandeur (P) de différence de tension fixe pour déterminer quand une des mesures de tension successives est plus grande que la somme.

12. Appareil selon la revendication 8, caractérisé en outre en ce que les moyens (70, 74, 87, 89, 80) pour déterminer la grandeur qui est une fonction de la tension de régime permanent à circuit ouvert prédite comprennent des moyens (74) pour additionner un facteur à une des mesures de tension et des moyens (20, 26, 30, 87, 89) pour déterminer le facteur nommé en dernier lieu comme une function de la vitesse de variation entre les mesures de tension.

13. Appareil selon la revendication 12, caractérisé en ce que les moyens de détermination du facteur (87, 89) fonctionnent pour déterminer le facteur nommé en dernier lieu comme une function substantiellement antilogarithmique de la variation de la tension par unité de temps.

14. Appareil selon la revendication 12, caractérisé en outre en ce que les moyens (20, 26, 30, 87, 89) pour déterminer ledit facteur comme fonction de la vitesse de variation entre les mesures de tension, comprennent un compteur numérique (20) pour mémoriser un nombre correspondant au changement de tension et des portes logiques (26, 30) connectées audit compteur (20) et fonctionnant pour déterminer différentes bandes de valeur pour la vitesse de variation et au moins un générateur de fonction de correction (87, 89) connectés auxdites portes logiques (30, 26) et fonctionnant en réponse à la détermination des bandes de valeur (à 100—106) pour la vitesse de variation pour fournir une valeur pour ledit facteur basée sur la bande déterminée de vitesse de variation de la tension.

15. Appareil selon la revendication 14, caractérisé en outre en ce que les moyens (20, 26, 30, 87, 89) pour déterminer ledit facteur en fonction de la vitesse de variation entre des mesures de tension comprennent en outre un circuit d'addition (142), ledit circuit d'addition étant connecté pour recevoir une des mesures de tension (de 24, 66, 70) et pour additionner une grandeur fixe (M) à ladite mesure de tension pour fournir une mesure de tension ajustée au niveau zéro et caractérisé en outre en ce que ledit générateur de fonction de correction (89) comprend un circuit multiplicateur connecté (144) pour recevoir la mesure de tension ajustée au niveau zéro dudit circuit d'addition (142), ledit multiplicateur (89) fonctionnant pour multiplier la mesure de tension ajustée au niveau zéro par différents facteurs choisis tels qu'ils sont choisis par les différentes bandes de vitesse de variation de la tension (à 126—132) pour produire ainsi une sortie de produit (86) comme ce facteur est déterminé en fonction de la vitesse de variation entre lesdites mesures de tension.

16. Appareil selon la revendication 7, caractérisé en outre en ce que lesdites moyens (18, 20) pour prendre les mesures de tension aux bornes de la batterie comprennent un oscillateur commandé par la tension (18) et un compteur numérique (20) connecté pour recevoir des impulsions d'oscillations de l'oscillateur commandé par la tension (18) pour compter ces impulsions comme mesure de la tension, lesdits moyens pour comparer une seconde mesure de la tension aux bornes de la batterie prise à un moment subséquent comprennent des moyens (48, 52) pour inverser le fonctionnement du compteur réversible (20) pendant la seconde mesure de la tension aux bornes de la batterie pour compter le compteur dans la direction inverse et que ces moyens pour comparer la seconde mesure de la tension aux bornes de la batterie avec la première mesure de la tension aux bornes de la batterie comprennent des moyens (78) pour déterminer si oui ou non le compteur réversible est commuté dans le mode complémentaire pour indiquer un reste négatif dans le compteur réversible comme une indication de la direction de changement de la tension.

17. Appareil selon la revendication 12, caractérisé en ce que des moens (70) sont prévus pour soustraire un facteur fixe d'une des mesures de la tension pour fournir une indication corrigée à zéro de l'état de charge par le moyen d'affichage (28).

18. Appareil selon la revendication 8, caractérisé en ce qu'en outre un moyen de mesure de la température (146, 148, 150) connecté auxdits moyens de fonction de la tension à régime permanent à circuit ouvert prédite (70, 87, 89) pour modifier le fonctionnement du moyen nommé en dernier lieu pour compenser les variations de température.

19. Appareil selon la revendication 8, caractérisé en outre en ce que les moyens pour mesurer l'intervalle de temps entre la première mesure de la tension aux bornes de la batterie et la seconde mesure de la tension aux bornes de la batterie comprennent un compteur numérique (22) et un oscillateur de mesure du temps (54), les étages d'ordre inférieur du compteur numérique (22) fonctionnant pour fournir des fonctions de commutation de commutateur de cadence pour ledit appareil.

FIG.1

# FIG.2

BATTERY TERMINAL VOLTS ON SCALE OF % OF CHARGE

- 100 % CHARGE — 1A
- 80 % CHARGE — 2A
- 60 % CHARGE — 3A
- 90% CHARGE
- 40% CHARGE — 4A
- 70% CHARGE
- 20% CHARGE
- 50 % CHARGE — 8A
- 30 % CHARGE — 7A
- 10 % CHARGE — 6A
- 0 % CHARGE — 14A
- 11A
- 9A
- 5A

QUIESCENT INTERVAL TIME IN HOURS

FIG.3

0 071 439

3

**0 071 439**

# FIG.4

4